# EUROPÄISCHE PATENTSCHRIFT

(11) **EP 2 434 846 B1**
(45) Veröffentlichungstag und Bekanntmachung des Hinweises auf die Patenterteilung: **05.03.2014**
(21) Anmeldenummer: 11182522.0
(22) Anmeldetag: 23.09.2011
(51) Int. Cl.: H05K 1/02, H05K 3/32, H05K 1/11

(54) **Verdrahtungselement, Leistungsverteiler und Fahrzeugbatterie**
Wiring element, power distributor, and vehicle battery
Élément de câblage, distributeur d'énergie, et batterie du véhicule

(30) Priorität: 24.09.2010 DE 102010041369
(43) Veröffentlichungstag der Anmeldung: 28.03.2012
(73) Patentinhaber: Herrler, Manfred, 91126 Schwabach (DE)
(72) Erfinder: Herrler, Manfred, 91126 Schwabach (DE)
(74) Vertreter: Friese, Martin

(56) Entgegenhaltungen:
- EP-A1- 2 187 465
- DE-A1- 3 905 657
- DE-A1- 4 325 499
- DE-A1- 4 424 984
- DE-A1-102006 021 096
- US-A- 5 381 306
- US-A1- 2010 013 085
- US-A1- 2010 062 329

## Beschreibung

Die Erfindung betrifft ein Verdrahtungselement für die Verdrahtung einer Mehrzahl elektrischer Bauteile, enthaltend zumindest eine Platine aus einem Material mit einer ersten elektrischen Leitfähigkeit, welche zumindest eine Leiterbahn aus einem Material mit einer zweiten elektrischen Leitfähigkeit und zumindest ein Anschlusselement trägt. Weiterhin betrifft die Erfindung Leistungsverteiler und Fahrzeugbatterien mit einem solchen Verdrahtungselement.

Verdrahtungselemente der eingangs genannten Art sind als gedruckte Leiterplatten aus der Praxis bekannt. Hierbei wird eine Platine aus einem kupferkaschierten Basismaterial mit Hilfe eines belichteten Fotolackes strukturiert, so dass die Oberfläche der Platine leitfähige und nicht leitfähige Bereiche aufweist. Die Platine dient dabei gleichzeitig zur mechanischen Befestigung einer Mehrzahl von Bauelementen sowie deren elektrischer Kontaktierung durch Leiterbahnen, welche auf der Platine fest haftend angebracht sind. Zum Anschluss externer Bauelemente, welche nicht auf der Oberfläche der Platine angeordnet sind, können Anschlusselemente vorgesehen sein, wie beispielsweise Schraubklemmen oder Steckverbinder.

Aufgrund des beschränkten Querschnittes der Leiterbahnen und der geringen mechanischen Elastizität des Platinenmaterials eignen sich diese bekannten Verdrahtungselemente weder zur Übertragung großer Ströme noch zur mechanischen Befestigung großer und schwerer Bauelemente. Die bekannten Verdraht-ungselemente sind daher auf Kleinsignalanwendungen beschränkt.

Für die Übertragung größerer Ströme und/oder die mechanische Befestigung schwerer elektromechanischer Bauelemente sind aus der DE 19724254 A1 Stanzgitter bekannt. Diese werden durch Schneiden und Biegen aus Blechtafeln mit einer Materialstärke von etwa 0,5 bis etwa 2 mm gefertigt. Solche Stanzgitter weisen jedoch den Nachteil auf, dass diese aufwändig gefertigt werden müssen und die Handhabung aufgrund der Vielzahl scharfer Kanten schwierig ist.

Aus der DE 10 2006 021 096 A1 ist ein Leiterbahnträger zum Kontaktieren von elektrischen Bauteilen bekannt, welcher eine flexible Basisfolie und eine auf der Basisfolie angeordnete Leiterbahn mit einem Kontaktierauge aufweist. Der bekannte Leiterbahnträger weist auf zwei einander gegenüberliegenden Seiten des Kontaktierungsabschnitts jeweils eine Aussparung auf und zwischen den Aussparungen sind Stegelemente so ausgebildet, dass der Abschnitt mit dem Kontaktierauge schwenkbar gelagert ist. Nachteilig ist jedoch die geringe mechanische Festigkeit der Basisfolie, so dass der Leiterbahnträger bei mechanischer Beanspruchung leicht versagt.

Die US 2010/0062329 A1 offenbart eine Fahrzeugbatterie, deren Batteriezellen über plattenförmige Verbinder untereinander kontaktiert sind. Eine auf der Batterie befestigte Leiterplatte ist über federnde, leitfähige Beilagscheiben kontaktiert und gelagert, welche sich auf den Verbindern abstützen.

Die EP 2 187 465 A1 zeigt eine Batterie, welche mehrere Batteriezellen enthält. Diese sind über verschweißte Verbindungselemente seriell verschaltet. Die Verbindungselemente weisen Kontaktfinger auf, welche in zugeordnete Öffnungen einer Platine eingreifen und dort verlötet werden können.

Aus der Offenlegungsschrift DE 43 25 499 A1 ist eine Elektronikeinheit mit einer in Folientechnik hergestellten Leiterplatte bekannt. Um die Leiterplatte bei Bewegungen der Verbrauchs vor zerstörung zu Schützen, ist in der Leiterplatte ein die Anschlusstellen umfassender Freischnitt ausgebildet, der einen zungenartigen Bereich umfasst.

Ausgehend von diesem Stand der Technik liegt der Erfindung daher die Aufgabe zugrunde, ein Verdrahtungselement anzugeben, welches einfach hergestellt und montiert werden kann, die einheitliche Verdrahtung von Kleinsignal- und Leistungselektronik ermöglicht und eine erhöhte Betriebssicherheit aufweist.

Weiterhin liegt der Erfindung die Aufgabe zugrunde, eine zuverlässige Fahrzeugbatterie bereitzustellen.

Die Aufgabe wird erfindungsgemäß durch ein Verdrahtungselement gemäß Anspruch 1 und eine Fahrzeugbatterie gemäß Anspruch 12 gelöst. Vorteilhafte Weiterbildungen des Verdrahtungselementes und vorteilhafte Anwendungen finden sich in den Unteransprüchen.

Erfindungsgemäß wird vorgeschlagen, zumindest eine Teilfläche der Platine durch Einbringen von zumindest einem Schlitz teilweise von der verbleibenden Fläche der Platine freizustellen, so dass ein auf dieser Teilfläche montiertes Anschlusselement in zumindest einer Raumrichtung soweit beweglich angeordnet ist, dass typische mechanische Toleranzen ausgeglichen werden können, ohne die Platine zu verspannen. Auf diese Weise wird der Bruch der Platine durch mechanische Spannungen vermieden, welche durch die Montage großer und schwerer Bauelemente und insbesondere durch die mechanischen Toleranzen der Anschlusselemente auftreten können.

Das Anschlusselement ist zur Kontaktierung von mehreren Bauteilen vorgesehen. Da mehrere Bauteile mit einem einzigen Anschlusselement verbunden sind, kann das Anschlusselement selbst zur Übertragung großer Ströme und/oder großer Spannungen ausgelegt sein, welche typischerweise nicht über eine auf der Oberfläche der Platine angebrachte Leiterbahn übertragen werden können. Gleichwohl kann eine solche Leiterbahn dazu verwendet werden, einen Teilstrom und/oder die am Anschlusselement anliegende elektrische Spannung zu einem anderen Anschlusselement oder einem anderen, auf der Platine angeordneten Bauelement zu übertragen.

Anders als die bekannten Stanzgitter eignet sich das vorgeschlagene Verdrahtungselement somit zur Integration von Kleinsignalelektronik. Gleichzeitig können mit dem vorgeschlagenen Verdrahtungselement auch große Ströme und/oder große Spannungen zwischen Bauelementen übertragen werden und/oder große und schwere Bauelemente verdrahtet werden, welche typischerweise aufgrund mechanischer Toleranzen eine unzulässige mechanische Spannung in der Platine hervorrufen würden.

Unter einem großen Strom wird dabei für die Zwecke der vorliegenden Erfindung ein Strom von mehr als 10 Ampere, mehr als 30 Ampere und insbesondere mehr als 50 Ampere verstanden. Unter einer großen Spannung im Sinne der vorliegenden Beschreibung wird eine Spannung von mehr als 500 Volt, mehr als 1 kV, mehr als 3 kV oder mehr als 10 kV verstanden.

Die Platine kann erfindungsgemäß aus einem Material mit einer ersten elektrischen Leitfähigkeit hergestellt sein. Die spezifische elektrische Leitfähigkeit kann ineinigen Ausführungsformen der Erfindung größer als 10⁶ **Ω** cm, größer als 10⁸ **Ω** cm oder größer als 10¹⁰ **Ω** cm sein. Die Platine enthält in den Ausführungsformen ein Phenolharz und/oder ein Epoxidharz sowie Glasfasergewebe und/oder Papier zur Aufnahme von Zugspannungen enthalten. In einigen Ausführungsformen der Erfindung kann die Platine auch Polytetrafluorethylen, eine Keramik oder Polyester enthalten.

Die Leiterbahn enthält demgegenüber ein Material mit einer zweiten elektrischen Leitfähigkeit. Die zweite elektrische Leitfähigkeit kann in einigen Ausführungsformen geringer sein als 10² **Ω̇**·cm, geringer als 1 **Ω·**cm oder geringer als 10⁻¹ **Ω·**cm. Für die Zwecke der vorliegenden Erfindung kann daher ein Material mit der ersten elektrischen Leitfähigkeit als isolierend und ein Material mit der zweiten elektrischen Leitfähigkeit als leitend bezeichnet werden. Die Anschlusselemente können aus demselben Material wie die zumindest eine Leiterbahn gefertigt sein oder ein anderes leitfähiges Material enthalten oder daraus bestehen.

In einigen Ausführungsformen der Erfindung kann zumindest ein Anschlusselement Kupfer enthalten oder daraus bestehen. In einigen Ausführungsformen kann das Anschlusselement und/oder die zumindest eine Leiterbahn mit einer Beschichtung versehen sein. Die Beschichtung kann Nickel und/oder Blei und/oder Zinn enthalten. Die Beschichtung kann durch Aufschmelzen, thermisches Spritzen und/oder außenstromlose oder galvanische Beschichtung aufgebracht sein. Auf diese Weise kann der nutzbare Querschnitt vergrößert und/oder die Lötbarkeit verbessert und/oder der Korrosionsschutz verbessert werden.

In einigen Ausführungsformen des Verdrahtungselementes kann der Kontaktbereich an drei Seiten von der verbleibenden Fläche der Platine durch einen Schlitz freigestellt sein. Auf diese Weise ergibt sich eine verbesserte Beweglichkeit des auf dem Kontaktbereich angeordneten Anschlusselementes, so dass größere mechanische Toleranzen ausgeglichen werden können, ohne einen Bruch in der Platine hervorzurufen.

In den Ausführungsformen der Erfindung ist der Kontaktbereich mit einem durch zumindest einen Schlitz von der verbleibenden Fläche der Platine getrennten Steg mit der Platine verbunden. Der Steg weist dabei einen geringeren Querschnitt auf als der Kontaktbereich. Auf diese Weise kann durch die Beweglichkeit des Steges, welcher nach Art einer Blattfeder wirkt, eine Toleranz in einer zur Fläche der Platine orthogonalen Richtung ausgeglichen werden. Gleichzeitig kann der Steg innerhalb der Fläche der Platine beweglich sein, so dass für den Kontaktbereich eine seitliche Verschwenkbarkeit gegeben ist. Auf diese Weise können auch Toleranzen in einer zur Längserstreckung des Steges orthogonalen Richtung ausgeglichen werden.

In einigen Ausführungsformen der Erfindung kann der Steg und der Kontaktbereich einen Winkel einschließen, welcher kleiner ist als 180°, insbesondere kleiner als 135°. In einigen Ausführungsformen der Erfindung kann der Winkel zwischen dem Steg und dem Kontaktbereich etwa 90° betragen. Da der Winkel zwischen dem Kontaktbereich und dem Steg durch die Elastizität des Materials der Platine bei Beaufschlagung mit einer mechanischen Spannung in gewissem Umfang variabel ist, kann eine solche Ausführungsform der Erfindung mechanische Toleranzen in allen drei Raumrichtungen ausgleichen, nämlich in einer Richtung orthogonal zur Fläche der Platine, in der Längserstreckung des Steges und in einer Richtung innerhalb der Ebene der Platine und orthogonal zur Längserstreckung des Steges.

In den Ausführungsformen der Erfindung weist die Platine einen mehrschichtigen Aufbau auf. Auf diese Weise kann zumindest eine Leiterbahn im Inneren der Platine verlaufen. In den Ausführungsformen der Erfindung sind eine Mehrzahl von Leiterbahnen in unterschiedlichen Schichten der Platine angeordnet. Beispielsweise kann sowohl die Ober- als auch die Unterseite der Platine mit je zumindest einer Leiterbahn versehen sein. Da die Platine einen mehrschichtigen Aufbau aufweist, kann zumindest eine Leiterbahn in jeder Schicht angeordnet sein, so dass eine Mehrzahl von Leiterbahnen in unterschiedlichen Schichten der Platine angeordnet ist. Die Ausführungsformen weisen eine erhöhte Zuverlässigkeit auf, da bei Bruch einer Leiterbahn noch weitere, redundante Leiterbahnen zur Verfügung stehen, um die entsprechenden Signale zu transportieren. Weiterhin kann ein mehrschichtiger Aufbau die Realisierung komplexer Schaltungen vereinfachen, da Leiterbahnen auf unterschiedlichen Ebenen gekreuzt werden können und/oder zumindest eine Leiterbahn mit einem definierten Wellenwiderstand und/oder einer Abschirmung über die Platine geführt werden kann. Die Anzahl der Schichten kann in den Ausführungsformen der Erfindung 2 bis 10 betragen.

In den Ausführungsformen der Erfindung ist im Steg eine Mehrzahl von Leiterbahnen zum Kontaktbereich geführt. Da bei Bewegung des Steges unterschiedliche Ebenen innerhalb des Steges unterschiedliche Biegeradien aufweisen, ist die Zuverlässigkeit des Verdrahtungselementes erhöht.

In den Ausführungsformen der Erfindung weist der Kontaktbereich zumindest eine Durchkontaktierung auf. Eine Durchkontaktierung im Sinne der vorliegenden Erfindung ist eine Bohrung, welche in etwa orthogonal zur Oberfläche der Platine verläuft. In einigen Ausführungsformen der Erfindung kann die die Durchkontaktierung bildende Bohrung mit einer leitfähigen Beschichtung an der Innenwand ausgestattet sein und auf diese Weise zumindest eine im Bereich der Durchkontaktierung verlaufende Leiterbahn elektrisch kontaktieren. Auf diese Weise können Leiterbahnen in unterschiedlichen Ebenen gleichstromgekoppelt werden. Weiterhin kann die Durchkontaktierung die Lötbarkeit des Anschlusselementes am Kontaktbereich verbessern, indem die Lötwärme auch von der Unterseite der Platine an den Kontaktbereich herangeführt wird. In einigen Ausführungsformen der Erfindung kann die Durchkontaktierung bewirken, dass Flussmittel, welches zum Auflösen einer Oxidschicht beim Löten verwendet wird, unten aus dem Kontaktbereich austritt, und die Gefahr der Bildung von Lunkern reduziert wird.

In einigen Ausführungsformen der Erfindung kann die mechanische Befestigung eines Anschlusselementes auf einem Kontaktbereich verbessert sein, da die Metallisierung der Durchkontaktierung zusätzlich als haftvermittelnde Schicht zur Verfügung steht.

In einigen Ausführungsformen der Erfindung kann das Anschlusselement einen gekröpften Grundkörper aufweisen. Der gekröpfte Grundkörper kann bewirken, dass die Beweglichkeit des Anschlusselementes in einer zur Fläche der Platine orthogonalen Richtung vergrößert ist.

Nachfolgend soll die Erfindung anhand von Ausführungsbeispielen ohne Beschränkung des allgemeinen Erfindungsgedankens näher erläutert werden, wobei einige Ausführungsbeispiele in den anliegenden Figuren dargestellt sind. Dabei zeigt:
- Figur 1: eine Aufsicht auf einen Kontaktbereich eines Verdrahtungselementes gemäß einer ersten Ausführungsform der Erfindung.
- Figur 2: zeigt eine Aufsicht auf einen Kontaktbereich eines Verdrahtungselementes gemäß einer zweiten Ausführungsform der Erfindung.
- Figur 3: zeigt eine Aufsicht auf einen Kontaktbereich eines Verdrahtungselementes gemäß einer dritten Ausführungsform der Erfindung.
- Figur 4: zeigt eine Pseudo-3D-Darstellung eines Anschlusselementes und eines Kontaktbereiches gemäß einer vierten Ausführungsform der Erfindung.
- Figur 5: zeigt den Querschnitt durch eine Platine und ein Anschlusselement gemäß einer fünften Ausführungsform der Erfindung.
- Figur 6: zeigt die Geometrie einer Platine gemäß der fünften Ausführungsform der Erfindung.
- Figur 7: zeigt die Aufsicht auf ein Anschlusselement gemäß einer Ausführungsform der Erfindung.
- Figur 8: zeigt den Querschnitt des Anschlusselementes gemäß Figur 7.
- Figur 9: zeigt eine Pseudo-3D-Darstellung des Anschlusselementes gemäß Figur 7.
- Figur 10: zeigt eine Aufsicht auf eine Fahrzeugbatterie mit einem Verdrahtungselement gemäß der vorliegenden Erfindung.

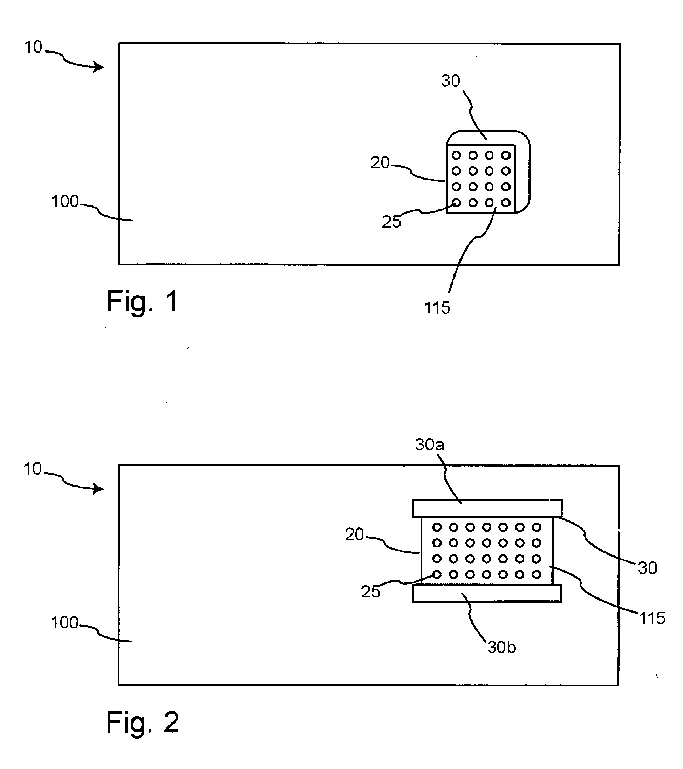

Figur 1 zeigt die Aufsicht auf eine Platine 100 eines Verdrahtungselementes 10. Aus Gründen der Übersichtlichkeit ist die zumindest eine Leiterbahn und das Anschlusselement nicht dargestellt. Das Verdrahtungselement kann die in Figur 1 dargestellte Außenkontur aufweisen. Figur 1 kann aber auch nur einen Ausschnitt aus der Oberfläche der Platine des Verdrahtungselementes zeigen. Insofern können auch mehrere der Kontaktbereiche gemäß den Figuren 1 bis 4 auf der Platine des Verdrahtungselementes angeordnet sein. Die Erfindung lehrt nicht die Anwesenheit eines einzigen Kontaktbereiches 20 als Lösungsprinzip.

Der Kontaktbereich 20 ist im Wesentlichen durch ein Lötpad 115 begrenzt. Das Lötpad 115 kann Teil einer auf der Oberfläche der Platine angeordneten Leiterbahn sein oder mittels zumindest einer Durchkontaktierung 25 mit zumindest einer Leiterbahn in Kontakt stehen, welche im Inneren der Platine und/oder auf der in Figur 1 nicht sichtbaren Unterseite der Platine angeordnet ist. Der Kontaktbereich 20 ist zumindest an zwei Seiten durch zumindest einen Schlitz 30 von der verbleibenden Oberfläche der Platine 100 separiert. Auf diese Weise kann der Kontaktbereich 20 zumindest teilweise aufgrund der Flexibilität des Materials der Platine 100 in einer Richtung orthogonal zur Oberfläche der Platine 100 verformt werden. Auf diese Weise kann das mit dem Kontaktbereich verbundene Anschlusselement mit einem Bauelement verbunden sein, dessen Anschlusskontakte toleranzbehaftet sind, d.h. deren Lage nicht in einer vorgebbaren Ebene verläuft, welche parallel zur Oberfläche der Platine 100 liegt. Falls solche Lagetoleranzen auftreten, können diese durch Verformung der den Kontaktbereich 20 bildenden Teilfläche der Platine 100 aufgenommen werden, ohne dass in der Platine 100 als Ganzes mechanische Spannungen erzeugt werden.

Das Lötpad 115 auf dem Kontaktbereich 20 und/oder die Leiterbahnen können in einigen Ausführungsformen der Erfindung eine Dicke von mehr als etwa 35 µm, mehr als etwa 70 µm oder mehr als etwa 140 µm aufweisen. Das Lötpad 115 kann Kupfer oder eine Kupferlegierung enthalten oder daraus bestehen.

Figur 2 zeigt eine zweite Ausführungsform eines Kontaktbereiches gemäß der vorliegenden Erfindung. Auch der Kontaktbereich 20 gemäß Figur 2 weist ein Lötpad 115 auf, wie im Zusammenhang mit Figur 1 erläutert. Der Kontaktbereich 20 ist an zwei Seiten durch die Grenzen des Lötpads 115 von der verbleibenden Fläche der Platine 100 abgegrenzt. Die Teilfläche, welche den Kontaktbereich 20 bildet, kann mit einer Mehrzahl von Durchkontaktierungen 25 versehen sein, wie in Zusammenhang mit Figur 1 bereits erläutert.

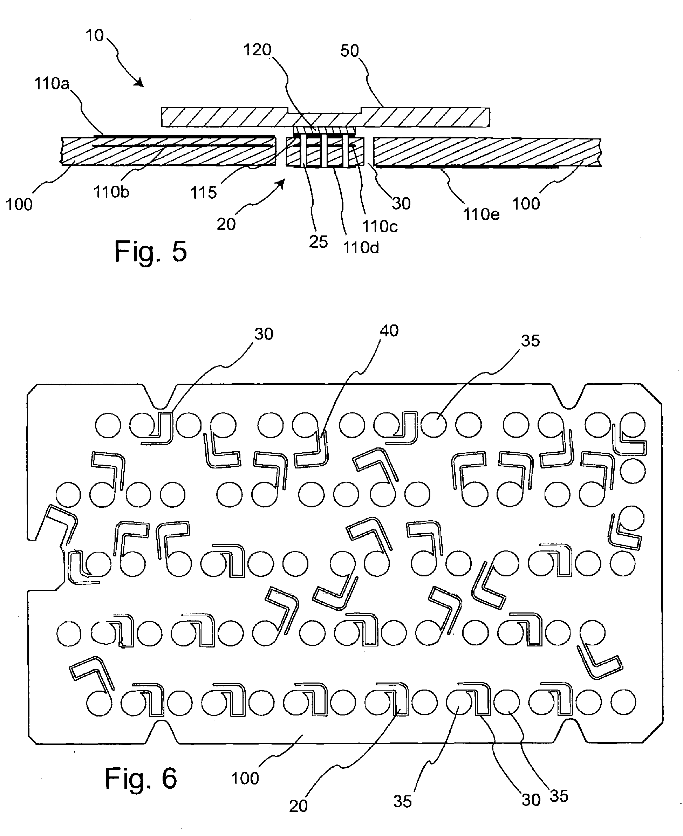

Um eine Beweglichkeit des Kontaktbereiches 20 in einer Richtung orthogonal zur Fläche der Platine 100 zu ermöglichen, ist der Kontaktbereich 20 an zwei gegenüberliegenden Seiten von je einem Schlitz 30a und 30b begrenzt. Die Schlitze 30a und 30b können beispielsweise durch Fräsen, Sägen oder Wasserstrahlschneiden in das Material der Platine 100 eingebracht werden. Wie in Zusammenhang mit Figur 5 noch erläutert wird, weisen die Schlitze eine Einfrästiefe auf, welche der Materialstärke der Platine 100 entspricht, so dass der von den Schlitzen 30a und 30b begrenzte Flächenbereich des Kontaktelementes 20 im Bereich der Schlitze 30 vollständig freigestellt ist.

In einigen Ausführungsformen der Erfindung können die Schlitze 30a und 30b eine größere Längserstreckung aufweisen wie das Lötpad 115. Auf diese Weise ergibt sich beidseitig des Lötpads 115 ein Überstand 31 des Schlitzes 30, welcher über den Kontaktbereich 20 übersteht. Durch die Wahl eines entsprechenden Überstandes 31 kann die Bewegungsamplitude und/oder die Federhärte des Kontaktbereiches 20 und damit die Beweglichkeit des auf dem Kontaktbereich 20 angeordneten Anschlusselementes festgelegt werden.

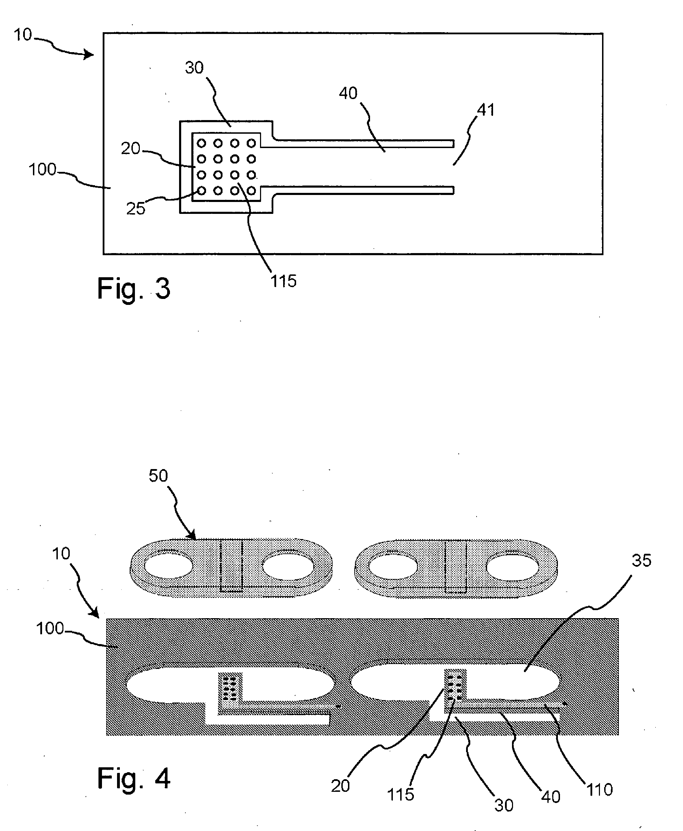

Figur 3 zeigt eine Aufsicht auf eine Platine 100 mit einem Kontaktbereich 20 gemäß einer dritten Ausführungsform der Erfindung. Der Kontaktbereich 20 ist an drei Seiten durch einen umlaufenden Schlitz 30 von der verbleibenden Fläche der Platine 100 freigestellt. Der Kontaktbereich 20 weist wiederum ein Lötpad 115 sowie zumindest eine Durchkontaktierung 25 und einen Anschluss an zumindest eine Leiterbahn auf, wie in Zusammenhang mit Figur 1 und 2 bereits erläutert.

In der in Figur 3 dargestellten Ausführungsform ist der Kontaktbereich 20 an einem Steg 40 angeordnet, welcher ebenfalls durch den Schlitz 30 von der verbleibenden Fläche der Platine 100 getrennt ist. Die zur Kontaktierung des Lötpads 115 verwendete, mindestens eine Leiterbahn verläuft bevorzugt ebenfalls auf oder im Steg 40 und von dessen Fußpunkt 41 weiter auf der verbleibenden Fläche der Platine 100 bis zum gewünschten Endpunkt.

Der Steg 40 erlaubt die freie Beweglichkeit des Kontaktbereiches 20 in einer Richtung orthogonal zur Fläche der Platine 100, indem der Steg 40 nach Art einer Blattfeder verformt wird. Weiterhin kann der Steg 40 in einigen Ausführungsformen der Erfindung auch innerhalb der Ebene der Platine 100 verformt werden, so dass der Kontaktbereich 20 eine seitliche Schwenkbewegung ausführen kann, welche in etwa kreisförmig um den Fußpunkt 41 des Steges 40 verläuft. Auf diese Weise kann die Ausführungsform gemäß Figur 3 Toleranzen in zwei Raumrichtungen ausgleichen und erlaubt damit eine zuverlässige Kontaktierung von Bauelementen, ohne die Platine 100 durch unzulässig große mechanische Spannungen zu zerstören.

Figur 4 zeigt eine Pseudo-3D-Darstellung einer vierten Ausführungsform der Erfindung. Dargestellt ist wiederum ein Ausschnitt aus der Fläche der Platine 100, in welchem zwei Kontaktbereiche 20 angeordnet sind.

Der Kontaktbereich 20 ist wiederum mit einem Lötpad 115 versehen, welches im dargestellten Ausführungsbeispiel eine Teilfläche des Kontaktbereiches 20 bedeckt. Das Lötpad 20 ist wiederum mit einer Mehrzahl von Durchkontaktierungen 25 versehen.

Der Kontaktbereich 20 ist mittels eines Steges 40 mit der verbleibenden Fläche der Platine 100 verbunden. Der Steg 40 und der Kontaktbereich 20 schließen einen Winkel zueinander ein, welcher in etwa 90° beträgt. In anderen Ausführungsformen der Erfindung kann der Winkel auch andere Werte annehmen. Durch die gewinkelte Anordnung des Kontaktbereiches 20 zum Steg 40 kann der Kontaktbereich 20 durch Verformung des Steges 40 Bewegungen in drei Raumrichtungen ausführen. Somit können Toleranzen des am Kontaktbereich 20 befestigten Bauteiles in allen drei Raumrichtungen ausgeglichen werden.

Die Beweglichkeit des Kontaktbereiches 20 kann in einigen Ausführungsformen der Erfindung zumindest 0.5 mm, zumindest 0.3 mm oder zumindest 0.1 mm betragen. Aufgrund der Beweglichkeit des Kontaktbereichs 20 kann die Platine 100 mit einer Mehrzahl von Bauteilen verbunden werden, ohne dass unzulässig große mechanische Spannungen auf die Platine 100 aufgeprägt werden und ohne dass die Platine 100 als Ganzes nennenswert verformt wird.

Die elektrische Kontaktierung der Lötpads 115 wird durch Leiterbahnen 110 vorgenommen. Die Leiterbahn 110 verläuft im dargestellten Ausführungsbeispiel auf der sichtbaren Oberfläche des Steges 40, welcher seinerseits eine Teilfläche der Platine 100 ist. Da die Platine 100 aus mehreren Materiallagen zusammengesetzt ist, ist das Lötpad 115 auch zusätzlich in anderen Ebenen der Platine 100 durch Leiterbahnen kontaktiert. Auch kann ein korrespondierends Lötpad 115 auf der Unterseite des Kontaktbereiches 20 angeordnet sein. Durch die redundante Kontaktierung des Lötpads 115 durch eine Mehrzahl von Leiterbahnen 110 kann die Zuverlässigkeit des Verdrahtungselementes vergrößert und/oder die Stromtragfähigkeit erhöht sein.

Im Bereich des Fußpunktes 41 des Steges 40 ist eine weitere Durchkontaktierung 25 angeordnet, welche zur Verbindung zweier Leiterbahnen in unterschiedlichen Ebenen der Platine dient.

Neben dem Steg 30 ist in der Platine 100 eine Aussparung 35 ausgebildet, welche in etwa komplementär zur Form des Anschlusselementes 50 ausgeführt ist. Auf diese Weise kann beim Ausgleich von Toleranzen in einer Bewegungsrichtung, welche in etwa orthogonal zur Fläche der Platine 100 verläuft, das Anschlusselement 50 in die Platine 100 eintauchen, ohne dass die Beweglichkeit des Anschlusselementes 50 durch Anstoßen auf der Oberfläche der Platine 100 begrenzt ist. Auch die Aussparung 35 kann wie der Schlitz 30 durch Fräsen, Sägen oder Schneiden aus der Platine 100 herausgearbeitet werden.

Die Form des Anschlusselementes 50 ist lediglich beispielhaft zu sehen. In anderen Ausführungsformen der Erfindung kann ein anderes Anschlusselement 50 vorgesehen sein, beispielsweise ein Steckverbinder.

Figur 5 zeigt einen Querschnitt durch eine Platine 100 im Bereich eines Kontaktbereiches 20 mit einem aufgesetzten Anschlusselement 50. Der Kontaktbereich 20 ist dabei durch einen rechtsseitigen und einen linksseitigen Schlitz 30 von der verbleibenden Fläche der Platine 100 freigestellt. Auf diese Weise ergibt sich eine Beweglichkeit des Kontaktbereiches 20 in einer Richtung orthogonal zur Fläche der Platine 100 sowie optional eine Beweglichkeit in der Ebene der Platine 100.

Der Kontaktbereich 20 ist mit zwei Leiterbahnen 110c und 110d versehen. Die Leiterbahn 110d verläuft dabei auf der Unterseite des Kontaktbereiches 20, wohingegen die Leiterbahn 110c im Inneren der Platine 100 verläuft. Auf der Oberseite der Platine ist ein Lötpad 115 ausgeführt, welche zumindest als Teilbeschichtung der Oberseite des Kontaktbereiches 20 ausgeführt ist.

Das Lötpad 115, die Leiterbahn 110c und die Leiterbahn 110d sind mittels zumindest einer Durchkontaktierung 25 miteinander verbunden. Die Durchkontaktierung 25 umfasst dabei eine Bohrung, welche in etwa orthogonal zur Oberfläche der Platine 100 verläuft sowie eine Metallisierung, welche zumindest als Teilbeschichtung der Begrenzungsflächen der Bohrung ausgeführt ist. Auf diese Weise sind das Lötpad 115, die Leiterbahn 110c und die Leiterbahn 110d gleichstromgekoppelt. In Figur 5 sind drei Durchkontaktierungen 25 dargestellt. Selbstverständlich kann die Anzahl der Durchkontaktierungen jedoch auch größer oder kleiner sein und etwa 50 betragen.

Im verbleibenden Flächenbereich der Platine 100 sind weitere Leiterbahnen 110a, 110b und 110e angeordnet. In anderen Ausführungsformen der Erfindung können die Leiterbahnen auch anders verlaufen. Weiterhin kann auch eine größere oder kleinere Anzahl von Leiterbahnen übereinander in der Platine 100 angeordnet sein. Die Erfindung lehrt nicht die dargestellte Anordnung von Leiterbahnen und die Verwendung von drei Ebenen als Lösungsprinzip.

Auf dem Lötpad 115 ist ein Anschlusselement 50 mittels einer Lötverbindung 120 angeordnet. Die Lötverbindung 120 kann mittels Reflow-Löten hergestellt sein. In diesem Fall können die Durchkontaktierungen 25 dazu dienen, Wärme von unten an das Lötpad 115 heranzuführen, so dass das Anschlusselement 50 nicht vollständig durchwärmt werden muss. Weiterhin kann überschüssiges Flussmittel während des Lötprozesses aus den Durchkontaktierungen 25 austreten, so dass die Gefahr der Bildung von Lunkern in der Lötverbindung 120 reduziert ist. Sofern die Durchkontaktierungen 25 ebenfalls mit einer lötfähigen Metallisierung versehen sind, vergrößert sich die Kontaktfläche der Lötverbindung 120, wodurch die Haftfestigkeit des Anschlusselementes 50 auf dem Lötpad 115 vergrößert werden kann.

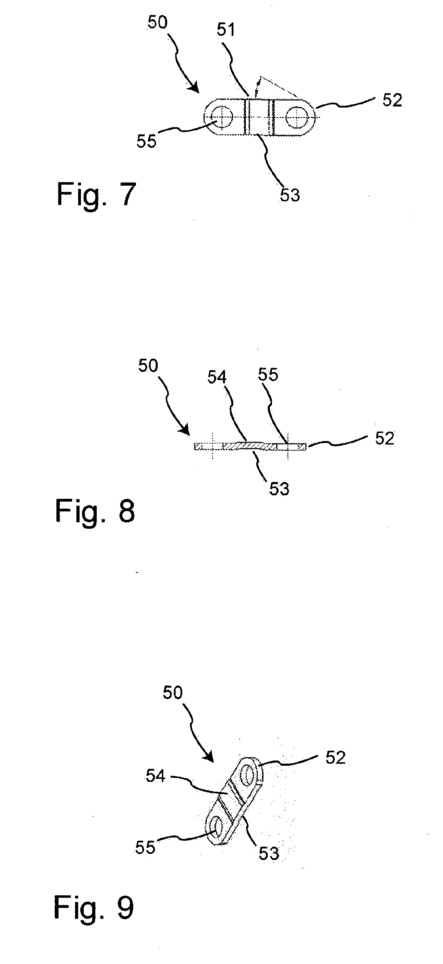

Das Anschlusselement 50 ist in Figur 5 nur schematisch dargestellt und wird anhand der Figuren 7 bis 9 näher erläutert.

Figur 6 zeigt die Aufsicht auf eine Platine gemäß einer fünften Ausführungsform der Erfindung. Figur 6 zeigt dabei das Fräsbild, welches zur Herstellung der Stege 40, der Ausnehmungen 35 und der Kontaktbereiche 20 verwendet wird. Daneben weist die Platine 100 Leiterbahnen 110 und Lötpads 115 und Durchkontaktierungen 25 auf, welche jedoch in Figur 6 nicht dargestellt sind. Figur 6 zeigt eine Ausführungsform der Erfindung mit einer Mehrzahl beweglicher Kontaktbereiche 20, welche jeweils zur Aufnahme eines nicht dargestellten Anschlusselementes 50 dienen. Zur Herstellung des Kontaktes zwischen dem Bauelement und dem Anschlusselement 50 ist eine Schraubverbindung vorgesehen, welche jeweils durch die Bohrung 35 hergestellt oder gelöst werden kann. Im Gegensatz zur Ausführungsform gemäß Figur 4 verbleibt zwischen dem Kontaktbereich 20 und der Bohrung 35 noch nutzbare Platinenfläche, so dass die Verdrahtung einer Vielzahl von Bauelementen auf der Platine 100 erleichtert sein kann.

Figur 7 zeigt eine Aufsicht auf eine mögliche Ausführungsform eines Verbindungselementes 50. Das Verbindungselement 50 weist eine längliche Grundform 51 auf, welche beispielsweise durch Stanzen, Fräsen oder Schneiden aus einem planen, leitfähigen Material bzw. einem Blech erhältlich ist. Beide Enden des Grundkörpers 51 sind mit einer optionalen Verrundung 52 versehen, welche unter einem vorgebbaren Winkel am Grundkörper 51 ansetzen. Auf diese Weise ergibt sich eine raumsparende Ausführung des Anschlusselementes 50 und eine problemlose Handhabung, da die Anzahl von scharfen Kanten reduziert ist.

Das Anschlusselement 50 weist zwei Bohrungen 55 auf, an welche zumindest ein elektrisches bzw. elektronisches Bauelement mittels zumindest einer Schraubverbindung kontaktierbar ist. Da das Anschlusselement 50 zwei Bohrungen 55 aufweist, können zwei Bauelemente an das Anschlusselement 50 kontaktiert werden. Somit kann das Anschlusselement 50 einerseits dazu dienen, die Bauelemente mit den Leiterbahnen bahnen der Platine 100 zu verbinden und andererseits dazu, eine hochstromfähige Verbindung zwischen den beiden Bauelementen herzustellen. Auf diese Weise können über das Anschlasselement 50 Ströme übertragen werden, welche größer sind als die typischerweise von den Leiterbahnen 110 auf der Platine 100 übertragbaren Ströme. Gleichzeitig kann aufgrund der Gleichstromkopplung des Anschlusselementes 50 mit dem Lötpad 115 ein elektrisches Kleinsignal von den Bauelementen abgenommen oder diesen zugeführt werden.

Wie aus den Figuren 8 und 9 ersichtlich, weist das dargestellte Ausführungsbeispiel eines Anschlusselementes 50 eine Dicke von etwa 0,5 mm bis etwa 3 mm auf. Das Anschlusselement 50 kann aus einem elektrisch leitfähigen Material bzw. einer Legierung gefertigt sein, wie beispielsweise Kupfer, Aluminium oder Messing.

Das Anschlusselement 50 kann im Mittelbereich eine Kröpfung 53 aufweisen, so dass der Kontaktbereich 54, mit welchem das Anschlusselement auf dem Kontaktbereich 20 der Platine 100 verlötet wird, über die Fläche des Grundkörpers 51 hinaus erhaben ist. Die Kröpfung 53 kann in einigen ausführungformen in etwa 1 mm, etwa 0,5 mm, etwa. 0,3 mm oder etwa 0,1 mm betragen. Auf diese Weise wird eine freie Beweglichdes Kontaktelementes 50 sichergestellt, ohne dass dieses auf der Oberfläche der Platine 100 anstößt.

Selbstverständlich ist das dargestellte Anschlusselement 50 nur ein einfaches Ausführungsbeispiel. In anderen Ausführungsformen der Erfindung kann das Anschlusselement 50 andersartig ausgestaltet sein, beispielsweise mehr als zwei Anschlussmöglichkeiten bieten, eine gekrümmte Grundform aufweisen oder statt der Bohrungen 5.5 zumindest einen Steckverbinder aufweisen, in welchen Bauelemente eingesteckt werden können.

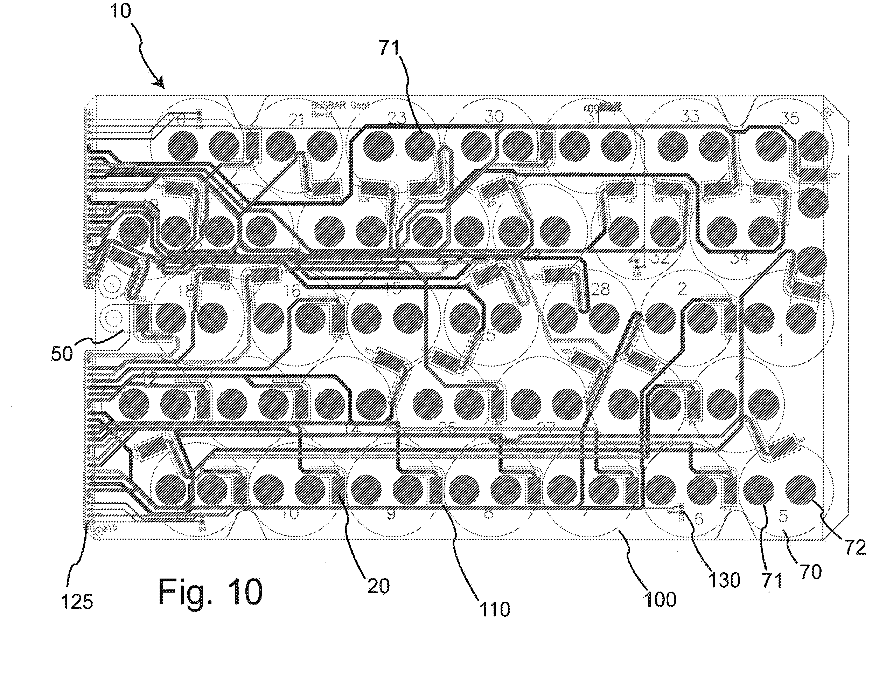

Figur 10 zeigt eine Aufsicht auf eine Fahrzeugbatterie mit einem Verdrahtungselement 10 gemäß der vorliegenden Erfindung. Die Fahrzeugbatterie weist im dargestellten Ausführungsbeispiel 35 Batteriezellen 70 mit zylindrischer Grundform auf. Jede Batteriezelle umfasst zwei Anschlusskontakte 71 und 72, über welche die elektrische Energie der Batteriezelle 70 abgegeben oder ein Ladestrom zugeführt wird. Um größere Spannungen und/oder größere Ströme bereitzustellen, als eine einzelne Batteriezelle 70 zu liefern im Stande ist, ist vorgesehen, die Batteriezellen 70 parallel und/oder in Serie miteinander zu verschalten. Hierzu dienen Anschlusselemente der in den Figuren 7 bis 9 gezeigten Art, welche auf Kontaktbereichen 20 einer Platine 100 angeordnet sind. Auf diese Weise können die Anschlusselemente 50 in einfacher Weise durch Aufsetzen der Platine 100 auf die Batteriezellen 70 positioniert und nachfolgend durch die Bohrungen 35 in der Platine 100 verschraubt werden. Somit sind jeweils zwei Batteriezellen 70 über das Anschlusselement 50 mit einer hochstromfesten Verbindung kontaktiert. Gleichzeitig ist die Kontaktstelle der beiden Batteriezellen über ein zugeordnetes Lötpad 115 und eine Mehrzahl von Leiterbahnen 110 kontaktiert, so dass die Anschlusskontakte für den Anschluss an eine Kleinsignalelektronik zugänglich sind.

Die Kleinsignalelektronik kann beispielsweise eine Spannungsmessung umfassen, um den Zustand der einzelnen Batteriezellen 70 zu überwachen. In anderen Ausführungsformen der Erfindung kann den Batteriezellen 70 über die Platine 100 ein Ladestrom und/oder ein Entladestrom zugeführt werden, um auf diese Weise einen Ausgleich unterschiedlicher Ladungszustände unterschiedlicher Batteriezellen 70 zu ermöglichen. Die für den Ladungsausgleich erforderliche Elektronik kann entweder auf der Platine 100 in an sich bekannter Weise integriert sein, beispielsweise in Form von zumindest einem SMD-Bauelement, welches als ASIC ausgeführt sein kann. In anderen Ausführungsformen der Erfindung kann die Elektronik zum Ladungsausgleich und/oder zur Überwachung der Batteriezellen 70 in einem externen Gehäuse angeordnet sein und über eine optionale Kontaktleiste 125 mit einem mehradrigen Kabel an die Platine 100 angeschlossen sein.

Als Ausführungsbeispiel für elektronische Bauelemente, welche auf der Platine 100 angeordnet sein können, ist in Figur 10 ein Widerstand 130 dargestellt, mit welchem eine Temperaturänderung der Batteriezellen 70 bestimmt werden kann. Selbstverständlich können in anderen Ausführungsformen der Erfindung auch andere elektronische Bauelemente auf der Platine 100 angeordnet sein, beispielsweise Induktivitäten, Kondensatoren, Sicherungen oder integrierte Schaltkreise.

In einer Ausführungsform der Erfindung kann das Verdrahtungselement als Teil einer Sicherungs- und Relaisbox bzw. eines Leistungsverteilers eingesetzt sein.

Leistungsverteiler finden insbesondere in Kraftfahrzeugen zur Verteilung hoher elektrischer Ströme Anwendung und sind z. B. Bestandteil von sogenannten Zentralelektriken. In den elektrischen Systemen von Kraftfahrzeugen stellen Zentralelektriken die Schnittstellen zwischen elektrischen bzw. elektronischen Steuergeräten und elektrischen Leitungen bzw. Leitungssträngen dar. Die Zentralelektrik erfüllt im Wesentlichen eine Verteilerfunktion, um elektrische Verbraucher des Kraftfahrzeugs, wie z. B. ABS, ESP, Scheibenwischer, Blinker u. ä. über elektrische Leitungen bzw. Kabelbäume mit elektrischem Strom bzw. elektrischer Spannung zu versorgen, und die Funktionstüchtigkeit dieser Verbraucher zu überwachen. Die Ansteuerung der elektrischen Verbraucher erfolgt dabei über Schaltgeräte, die in der Zentralelektrik gemeinsam mit Sicherungen der Verbraucherstromkreise steckbar angeordnet sind. Ferner können Zentralelektriken Steckplätze für Schalter, Widerstände, Relais, Lötkontakte, Pins, u. ä., sowie Anschlussmöglichkeiten für mit elektrischen Kupplungsorganen versehene Kabelbäume aufweisen.

In einer erfindungsgemäßen Weiterbildung einer solchen Zentralelektrik kann auf der Platine des Verdrahtungselementes zumindest ein weiteres elektronisches Bauelement angeordnet sein, so dass elektronische Steuergeräte nicht mehr über Steckverbinder und Kabel angeschlossen werden müssen, sondern als integraler Bestandteil auf der Platine des Verdrahtungselementes realisiert werden können. Somit kann die Platine eine Überwachungselektronik, eine Motorsteuerung, eine ABS- oder ESP-Steuerung und/oder weitere Steuergeräte aufnehmen, welche Kleinsignale verarbeiten. Gleichzeitig kann die Platine Anschlusselemente tragen, von welchen diese Kleinsignale abgenommen werden, welche aber selbst wieder eine Hochstromverbindung bereitstellen, um elektrische Leistung für Großverbraucher wie Radio, Heckscheibenheizung, Sitzheizung, Servolenkung, Scheinwerfer oder ähnliche Verbraucher bereit zu stellen, welche über Sicherungen und/oder Relais angeschlossen sind. Da die Anschlusselemente über bewegliche Kontaktbereiche 20 auf der Platine gehalten werden, können diese die beim Stecken und Lösen auftretenden Kräfte aufnehmen und mechanische Toleranzen ausgleichen, ohne eine mechanische Spannung in der Platine zu induzieren, welche zum Bruch und damit zum Ausfall der Elektronik führen könnte.

Selbstverständlich erlaubt das in der vorstehenden Beschreibung offenbarte Lösungsprinzip auch Abwandlungen, ohne den allgemeinen Erfindungsgedanken zu verlassen. Die vorstehende Beschreibung ist daher nicht als beschränkend, sondern dern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Ansprüche und die Beschreibung "erste", "zweite", "dritte" und "vierte" Merkmale definieren, so dient diese Bezeichnung der Unterscheidung gleichartiger Merkmale, ohne eine Rangfolge festzulegen.

## Patentansprüche

1. Verdrahtungselement (10) für die Verdrahtung einer Mehrzahl elektrischer Bauteile, enthaltend zumindest eine Platine (100) aus einem isolierenden Material, welche zumindest eine Leiterbahn (110) aus einem leitenden Material und zumindest ein Anschlusselement (50) trägt, wobei das Anschlusselement (50) dazu eingerichtet ist, zumindest zwei Bauelemente (70) miteinander zu verbinden und das Anschlusselement (50) mit einem Kontaktbereich (20) der Platine (100) verbunden ist, welcher eine Teilfläche der Fläche der Platine (100) einnimmt, und die Platine ein Phenolharz und/oder ein Epoxidharz sowie Glasfasergewebe und/oder Papier enthält, **dadurch gekennzeichnet, dass** der Kontaktbereich (20) an zumindest zwei Seiten von der verbleibenden Fläche der Platine durch zumindest einen Schlitz (30) freigestellt ist, so dass der Kontaktbereich (20) mit der verbleibenden Fläche der Platine (100) durch einen Steg (40) verbunden ist, und die Platine (100) einen mehrschichtigen Aufbau aufweist und eine Mehrzahl von Leiterbahnen (110) trägt, welche in unterschiedlichen Schichten der Platine (100) angeordnet sind, wobei im Steg (40) eine Mehrzahl von Leiterbahnen (110) in unterschiedlichen Schichten zum Kontaktbereich (20) geführt sind und der Kontaktbereich (20) zumindest ein Lötpad (115) und zumindest eine Durchkontaktierung (25) aufweist, so dass das Lötpad (115) mit der Mehrzahl von Leiterbahnen (110) redundant kontaktiert ist.

2. Verdrahtungselement nach Anspruch 1, **dadurch gekennzeichnet, dass** der Kontaktbereich (20) an drei Seiten von der verbleibenden Fläche der Platine (100) durch einen Schlitz (30) freigestellt ist.

3. Verdrahtungselement nach Anspruch 1 oder 2, dadurch gekenn-zeichnet, dass der Steg (40) und der Kontaktbereich (20) einen Winkel einschließen, welcher kleiner ist als 180°, insbesondere kleiner als 135° und insbesondere etwa 90° beträgt.

4. Verdrahtungselement nach einem der Ansprüche 1 bis 3, **dadurch gekennzeichnet, dass** das Anschlusselement (50) mittels einer Lötverbindung (120) auf dem Lötpad (115) befestigt ist.

5. Verdrahtungselement nach einem der Ansprüche 1 bis 4, **dadurch gekennzeichnet, dass** das Anschlusselement (50) einen gekröpften Grundkörper (51) aufweist.

6. Verdrahtungselement nach einem der Ansprüche 1 bis 5, **dadurch gekennzeichnet, dass** auf der Platine (100) zumindest ein weiteres Bauelement (130) angeordnet ist, welches insbesondere ausgewählt ist aus einem Widerstand, einer Induktivität, einem Kondensator, einem integrierten Schaltkreis und/oder einer Sicherung.

7. Verdrahtungselement nach einem der Ansprüche 1 bis 6, **dadurch gekennzeichnet, dass** auf der Platine (100) eine Kleinsignalelektronik zur Überwachung des Zustandes einzelner Batteriezellen angeordnet ist.

8. Verdrahtungselement nach einem der Ansprüche 1-7, **dadurch gekennzeichnet, dass** das Lötpad (115) und die Mehrzahl von Leiterbahnen (110c, 110d) gleichstromgekoppelt sind.

9. Verdrahtungselement nach einem der Ansprüche 1-8, **dadurch gekennzeichnet, dass** ein korrespondierendes Lötpad (115) auf der Unterseite der Platine (100) vorhanden ist.

10. Leistungsverteiler für ein Kraftfahrzeug mit zumindest einem Verdrahtungselement nach einem der Ansprüche 1 bis 9.

11. Leistungsverteiler für ein Kraftfahrzeug nach Anspruch 10, **dadurch gekennzeichnet, dass** die Platine eine Überwachungselektronik, eine Motorsteuerung, eine ABS- oder ESP-Steuerung und/oder weitere Steuergeräte aufnimmt.

12. Fahrzeugbatterie, enthaltend eine Mehrzahl von Batteriezellen und ein Verdrahtungselement nach einem der Ansprüche 1 bis 9.

## Claims

1. Wiring element (10) for wiring a plurality of electric components, containing at least one pc board (100) which is made of an insulating material and carries at least one conducting track (110) made of a conductive material and at least one connecting element (50), wherein the connecting element (50) is adapted to connect at least two components (70) with one another and the connecting element (50) is connected to a contact area (20) of the pc board (100), said contact area occupying a subarea of the area of the pc board (100), and the pc board contains a phenolic resin and/or an epoxy resin as well as glass fiber fabric and/or paper, **characterized in that** the contact area (20) is separated on at least two sides from the remaining area of the pc board by at least one slit (30) so as to connect the contact area (20) to the remaining area of the pc board (100) by a web (40) and
the pc board (100) has a multi-layered design and carries a plurality of pc boards (110) which are arranged in different layers of the pc board (100), wherein a plurality of conducting tracks (110) are conducted in the web (40) to the contact area (20) in different layers and the contact area (20) has at least one solder pad (115) and at least one through-connection (25) so as to redundantly contact the solder pad (115) with the plurality of conducting tracks (110).

2. Wiring element according to claim 1, **characterized in that** the contact area (20) is separated on three sides from the remaining area of the pc board (100) by a slit (30).

3. Wiring element according to claim 1 or 2, **characterized in that** the web (40) and the contact area (20) enclose an angle which is less than 180°, in particular less than 135° and in particular about 90°.

4. Wiring element according to any of claims 1 to 3, **characterized in that** the connecting element (50) is mounted on the solder pad (115) by means of a soldered connection (120).

5. Wiring element according to any of claims 1 to 4, **characterized in that** the connecting element (50) has a cranked basic body (51).

6. Wiring element according to any of claims 1 to 5, **characterized in that** at least one further component (130) is arranged on the pc board (100) and is especially selected from a resistor, an inductance, a capacitor, an integrated circuit and/or a protector.

7. Wiring element according to any of claims 1 to 6, **characterized in that** a small signal electronics for monitoring the state of individual battery cells is arranged on the pc board (100).

8. Wiring element according to any of claims 1 to 7, **characterized in that** the solder pad (115) and the plurality of conducting tracks (110c, 110d) are DC coupled.

9. Wiring element according to any of claims 1 to 8, **characterized in that** a corresponding solder pad (115) is present on the lower side of the pc board (100).

10. Power distributor for a motor vehicle, comprising at least one wiring element according to any of claims 1 to 9.

11. Power distributor for a motor vehicle according to claim 10, **characterized in that** the pc board accommodates a monitoring electronics, a motor controller, an ABS or ESP controller and/or further control devices.

12. Vehicle battery, containing a plurality of battery cells and a wiring element according to any of claims 1 to 9.

## Revendications

1. Élément de câblage (10) pour le câblage d'une pluralité de composants électriques, comprenant au moins une platine (100) en un matériau isolant, qui porte au moins une piste conductrice (110) en un matériau conducteur et au moins un élément de connexion (50), dans lequel l'élément de connexion (50) est conçu pour relier l'un l'autre au moins deux composants (70), et l'élément de connexion (50) est relié à une zone de contact (20) de la platine (100) qui occupe une surface partielle de la platine (100), et la platine contient une résine phénolique et/ou une résine époxy ainsi qu'un tissu en fibres de verre et/ou du papier,
la zone de contact (20) est dégagée sur au moins deux côtés de la surface restante de la platine par au moins une fente (30), de sorte que la zone de contact (20) est reliée à la surface restante de la platine (100) par une barrette (40), et
**caractérisé en ce que**
la platine (100) porte une superstructure multicouche et porte une pluralité de pistes conductrices (110) qui sont agencées dans des couches différentes de la platine (100), dans lequel dans la barrette (40) sont menées une pluralité de pistes conductrices (110) dans des couches différentes jusqu'à la zone de contact (20) et la zone de contact (20) comporte au moins un patin de brasage (115) et au moins un trou métallisé (25), de sorte que le patin de brasage (11.5) est mis en contact de façon redondante avec la pluralité de pistes conductrices (110).

2. Élément de câblage selon la revendication 1, **caractérisé en ce que** la zone de contact (20) est dégagée sur trois côtés de la surface restante de la platine (100) par une fente (30).

3. Élément de câblage selon la revendication 1 ou 2,
**caractérisé en ce que** la barrette (40) et la zone de contact (20) définissent un angle qui est plus petit que 180°, en particulier plus petit que 135°, et s'élève en particulier à environ 90°.

4. élément de câblage selon l'une des revendications 1 à 3,
**caractérisé en ce que** l'élément de connexion (50) est fixé sur le patin de brasage (115) au moyen d'une liaison brasée (120).

5. Élément de câblage selon l'une des revendications 1 à 4, **caractérisé en ce que** l'élément de connexion (50) comprend un corps de base coudé (51).

6. Élément de câblage selon l'une des revendications 1 à 5, **caractérisé en ce qu'**au moins un autre composant (130) est agencé sur la platine (100), lequel est en particulier choisi parmi une résistance, une inductance, un condensateur, un circuit intégré et/ou un fusible.

7. Élément de câblage selon l'une des revendications 1 à 6, **caractérisé en ce qu'**un système électronique pour faibles signaux est agencé sur la platine (100) pour surveiller l'état de cellules individuelles d'une batterie.

8. Élément de câblage selon l'une des revendications 1 à 7, **caractérisé en ce que** le patin de brasage (115) et la pluralité de pistes conductrices (110c, 110d) sont couplés vis-à-vis des courants continus.

9. Élément de câblage selon l'une des revendications 1 à 8, **caractérisé en ce qu'**un patin de brasage (115) correspondant est prévu sur la face inférieure de la platine (100).

10. Distributeur de puissance pour un véhicule automobile comprenant au moins un élément de câblage selon l'une des revendications 1. à 9.

11. Distributeur de puissance pour un véhicule automobile selon la revendication 10, **caractérisé en ce que** la platine reçoit un système électronique de surveillance, une commande moteur, une commande ABS ou ESP et/ou d'autres dispositifs de commande.

12. Batterie de véhicule, comprenant une pluralité de cellules de batterie et un élément de câblage selon l'une des revendications 1 à 9.
